(19) Europäisches Patentamt / European Patent Office / Office européen des brevets

(11) **EP 4 084 425 A1**

(12) **EUROPEAN PATENT APPLICATION**

(43) Date of publication:
02.11.2022 Bulletin 2022/44

(21) Application number: 21171281.5

(22) Date of filing: 29.04.2021

(51) International Patent Classification (IPC):
**H04L 25/03** (2006.01)

(52) Cooperative Patent Classification (CPC):
**H04L 25/03133; H03F 1/32;** H03F 2200/294;
H03M 1/06

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Rohde & Schwarz GmbH & Co. KG
81671 München (DE)**

(72) Inventor: **Nitsch, Bernhard
81671 München (DE)**

(74) Representative: **Prinz & Partner mbB
Patent- und Rechtsanwälte
Rundfunkplatz 2
80335 München (DE)**

(54) **METHOD FOR DETERMINING FILTER COEFFICIENTS AND EQUALIZER MODULE**

(57) A method for determining filter coefficients of an equalizer module (14) for equalizing a non-linear electronic system is described. The equalizer module (14) comprises a Volterra filter module (16). The method comprises the following steps:
- processing an input signal by means of the non-linear electronic system, thereby obtaining an output signal;
- providing a first mathematical model, wherein the first mathematical model describes the non-linear electronic system in terms of a first Volterra series;
- providing a second mathematical model, wherein the second mathematical model describes the Volterra filter module (16) in terms of a second Volterra series;
- determining reference transfer functions of the Volterra filter module (16) by means of a Pth order inverse technique based on the first Volterra series; and
- determining filter coefficients of the Volterra filter module (16) based on the determined reference transfer functions and based on the second Volterra series.

Further, an equalizer module (14) for equalizing a non-linear electronic system and an electronic device (10) are described.

**Fig. 1**

**Description**

The invention generally relates to a method for determining filter coefficients of an equalizer module for equalizing a non-linear electronic system. The invention further relates to an equalizer module for equalizing a non-linear electronic system, and to an electronic device.

Signal-processing electronic components may bear one or several different types of imperfections that cause unwanted distortions of output signals of the signal-processing electronic component.

In the state of the art, linear equalizers are known that are configured to remove such unwanted distortions. However, these equalizers only work correctly if the electronic component can be approximated to have a linear behavior with sufficient accuracy.

If the electronic component exhibits a non-linear behavior or if narrow precision limits are to be complied with, linear equalizers may not be sufficient to equalize the output signal of the electronic component.

Accordingly, the object of the present invention is to provide a possibility to equalize non-linear electronic systems.

According to the invention, the problem is solved by a method for determining filter coefficients of an equalizer module for equalizing a non-linear electronic system. The equalizer module comprises a Volterra filter module. The method comprises the following steps:

-   providing an input signal;

-   processing the input signal by means of the non-linear electronic system, thereby obtaining an output signal;

-   providing a first mathematical model, wherein the first mathematical model describes the non-linear electronic system in terms of a first Volterra series;

-   providing a second mathematical model, wherein the second mathematical model describes the Volterra filter module in terms of a second Volterra series;

-   determining reference transfer functions of the Volterra filter module by means of a Pth order inverse technique based on the first Volterra series; and

-   determining filter coefficients of the Volterra filter module based on the determined reference transfer functions and based on the second Volterra series.

The method according to the present invention is based on the idea to describe the non-linear electronic system in terms of the first Volterra series, and to describe the Volterra filter module in terms of the second Volterra series.

In general, Volterra series can be used to describe non-linear systems that are frequency-dependent and independent of a signal level.

In frequency domain, the first Volterra series may describe an overall transfer function of the non-linear electronic system. In time domain, the first Volterra series may describe an overall impulse response of the non-linear electronic system.

In frequency domain, the second Volterra series may describe an overall transfer function of the Volterra filter module. In time domain, the second Volterra series may describe an overall impulse response of the Volterra filter module.

Based on the mathematical models of the non-linear electronic system and of the Volterra filter module, the filter coefficients of the Volterra filter module can be derived such that non-linear distortions of the output signal are compensated by the Volterra filter module.

With the Pth order inverse technique, the reference transfer functions of the Volterra filter module are determined iteratively, namely order by order. Thus, the first order reference transfer functions are determined based on a first condition. Then, the second order reference transfer functions are determined based on a second condition and based on the first order reference transfer functions already determined. Finally, the third order reference transfer functions are determined based on a third condition and based on the first order reference transfer functions and the second order reference transfer functions already determined. In principle, further orders could also be determined by means of the Pth order inverse technique.

Alternatively, reference impulse responses of the Volterra filter module are determined iteratively by means of the Pth order inverse technique. Thus, the first order reference impulse responses are determined based on a first condition. Then, the second order reference impulse responses are determined based on a second condition and based on the first order impulse responses already determined. Finally, the third order reference impulse responses are determined based on a third condition and based on the first order reference impulse responses and the second order reference impulse responses already determined. In principle, further orders could also be determined by means of the Pth order inverse technique.

The reference transfer functions of the Volterra filter module may then be determined based on reference impulse responses by means of a Fourier transform.

The provided input signal may be a calibration signal that is used in order to calibrate the equalizer module or rather the Volterra filter module.

Accordingly, the input signal may have predefined and known properties, i.e. a known spectrum, known amplitudes and/or known phases.

The input signal may be received from an external electronic device, for example from a signal generator or from a device under test. Alternatively, the input signal may be generated by a further internal electronic component of the electronic system.

Therein and in the following, the term "non-linear electronic system" is understood to denote a single non-linear electronic component or a plurality of non-linear electronic components that are interconnected in an arbitrary manner.

According to an aspect of the present invention, an order of the first Volterra series and/or an order of the second Volterra series is smaller than or equal to three. It has turned out that a maximum order of three for the first Volterra series and/or for the second Volterra series yields a sufficient accuracy for the filter coefficients of the Volterra filter module. At the same time, restricting the maximum order to three reduces the numerical complexity and thus the necessary computing resources. Particularly, less hardware multipliers may be necessary when the maximum order is restricted to three.

According to a further aspect of the present invention, transfer functions of the non-linear electronic system are determined based on the input signal, the output signal, and the first Volterra series, wherein the reference transfer functions of the Volterra filter module are determined based on the determined transfer functions of the non-linear electronic system. More precisely, the reference transfer functions may be determined based on the transfer functions of the non-linear electronic system by means of the Pth order inverse technique.

Alternatively, impulse responses of the non-linear electronic system may be determined based on the input signal, the output signal, and the first Volterra series, wherein the reference transfer functions of the Volterra filter module are determined based on the determined impulse responses of the non-linear electronic system. More precisely, reference impulse responses of the Volterra filter module may be determined based on the impulse responses of the non-linear electronic system by means of the Pth order inverse technique. The reference transfer functions may then be determined based on reference impulse responses by means of a Fourier transform.

In an embodiment of the present invention, the filter coefficients of the Volterra filter module are determined based on the determined reference transfer functions via a least squares method. In other words, the filter coefficients may be determined such that a mean squared error of the output signal of the Volterra filter module is minimized.

In a further embodiment of the present invention, a cost functional is provided, wherein the cost functional describes a spectral error signal power in dependence of the reference transfer functions, and wherein the cost functional is minimized in order to determine the filter coefficients of the Volterra filter module. In other words, the filter coefficients may be determined such that the mean power of the spectral error signal (i.e. of the deviation of the actual output signal of the Volterra filter module from an optimal output signal) is minimized. Particularly, the cost functional may be minimized by means of a least squares technique.

According to a further embodiment of the present invention, the cost functional comprises a spectral weighting function. With the spectral weighting function, the spectral quality of the Volterra filter module can be controlled. In other words, the spectral quality of the Volterra filter module can be set to a desired value by choosing an appropriate spectral weighting function. It has turned out that a particular high equalization accuracy is achievable this way.

According to another aspect of the present invention, the reference transfer functions of the Volterra filter module are obtained by means of a Pth order inverse technique in frequency domain. Particularly, the Pth order inverse technique may be applied to the transfer functions of the non-linear electronic system. In other words, the reference transfer functions may be obtained directly by means of the Pth order inverse technique in frequency domain.

Alternatively, the reference transfer functions of the Volterra filter module are obtained by means of a Pth order inverse technique in time domain. More precisely, reference impulse responses are determined via the Pth order inverse technique applied to the impulse responses of the non-linear electronic system in time domain, and the reference transfer functions are determined based on the reference impulse responses by means of a Fourier transform.

In a further embodiment of the present invention, the filter coefficients of the Volterra filter module are pruned. Therein and in the following, the term "pruned" is understood to mean that several filter coefficients are set to zero. This way, the numerical complexity of determining the filter coefficients is reduced. Moreover, the equalization time needed by the Volterra filter module in order to equalize the output signal is also reduced.

If only filter coefficients of the main diagonal of the impulse responses of the Volterra filter module are non-zero, the second Volterra series may also be called a "memory polynomial". If only few diagonals of the impulse responses are non-zero, the second Volterra series may also be called an "extended memory polynomial".

According to another aspect of the present invention, the filter coefficients are pruned such that frequency superpositions are reduced. In non-linear systems, there may be a superposition of contributions from different input signal frequencies contributing to the same output signal frequency. Such ambiguities can occur within the same order of the Volterra series and/or across different orders of the Volterra series. For example, within the order m = 2, all frequencies $\{-f_{in}/f_a, + f_{in}/f_a\}$ always superpose to give an output frequency of zero. Within the order m = 3, the input frequencies $\{-f_{in,0}/f_a, +f_{in,0}/f_a, +f_{in,1}/f_a\}$ always yield an output frequency $f_{out}/f_a = f_{in,1}/f_a$. There is a certain freedom in putting some of the filter coefficients of the Volterra filter module to zero, thereby avoiding at least some of the frequency superpositions.

According to a further aspect of the present invention, the input signal is a multi-frequency signal, wherein the multi-frequency signal comprises several different signal components having a different predefined frequency, respectively, particularly wherein the multi-frequency signal comprises at least three different signal components. In order to fully characterize a Volterra system of maximum order $M = 3$, a minimum number $N_T = 3$ of different signal components having different frequencies is required.

Particularly, the predefined frequencies are chosen such that frequency superpositions are reduced. More precisely, the predefined frequencies of the input signal are chosen such that only unavoidable frequency superpositions remain and there are no avoidable frequency superpositions. The correct input frequencies can, for example, be found by solving a corresponding optimization problem with an intelligent search technique.

According to the invention, the problem further is solved by an equalizer module for equalizing a non-linear electronic system. The equalizer module comprises a Volterra filter module. Filter coefficients of the Volterra filter module are determined by means of a method described above.

Regarding the advantages and further properties of the equalizer module, reference is made to the explanations given above with respect to the method, which also hold for the equalizer module and vice versa.

Particularly, the first Volterra series is determined based on the input signal and the output signal. Accordingly, samples associated with the input signal and samples associated with the output signal may be determined in order to determine the first Volterra series.

According to the invention, the problem further is solved by an electronic device, comprising an equalizer module described above.

Regarding the advantages and further properties of the electronic device, reference is made to the explanations given above with respect to the method, which also hold for the electronic device and vice versa.

According to an aspect of the present invention, the electronic device is established as at least one of a measurement instrument, a broad-band amplifier, an analog-to-digital converter, a digital-to-analog converter, and a signal generator. The equalizer module may respectively be configured to compensate non-linear distortions originating from external components of the electronic device and/or from internal components of the electronic device.

Particularly, in the case of the digital-to-analog converter and in the case of the signal generator, the equalizer module may be configured to pre-compensate non-linear distortions caused by the digital-to-analog converter or by the signal generator, respectively.

According to another aspect of the present invention, the electronic device is established as an oscilloscope. Alternatively, the electronic device may be established as any other type of measurement instrument, for example as a signal analyzer or as a vector network analyzer.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows an electronic device according to a first variant of the present invention;

- Figure 2 schematically shows an electronic device according to a second variant of the present invention;

- Figure 3 shows a flowchart of a method for determining filter coefficients according to the present invention; and

- Figure 4 schematically shows an implementation of an equalizer module according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

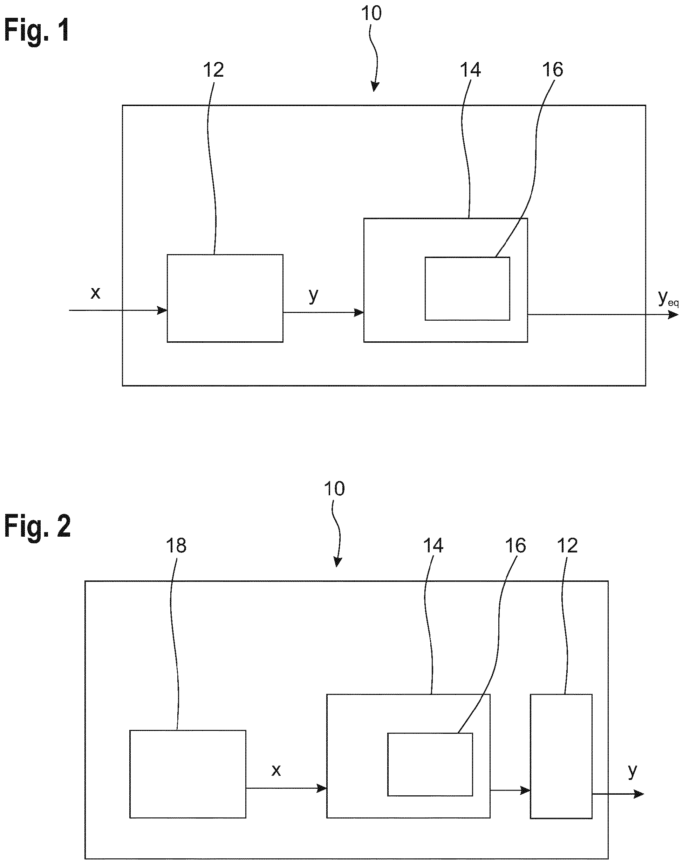

Figure 1 schematically shows an electronic device 10. The electronic device 10 comprises a non-linear electronic component 12 and an equalizer module 14.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

In general, the electronic device 10 may be any kind of signal-processing electronic device or signal-generating electronic device.

For example, the electronic device 10 may be established as a measurement instrument, as a broad-band amplifier, as an analog-to-digital converter, as a digital-to-analog converter, or as a signal generator.

Particularly, the electronic device 10 may be established as an oscilloscope.

The non-linear electronic component 12 may be any electronic component that is configured to process an input signal x, thereby generating an output signal y.

For example, the non-linear electronic component 12 may be an amplifier, an analog-to-digital converter, or a digital-to-analog converter.

Therein, the dependence of the output signal y on the input signal x is not linear, but comprises higher order terms. Accordingly, the output signal y is a function of the input signal x and can be written as follows

$$y = A \cdot x + O(x^2),$$

i.e. as a linear term plus higher order terms. Therein, $y = (y(n = 0), y(n = 1), ...)^T$ is a vector comprising the output signal samples $y(n)$, and $x = (x(n = 0), x(n = 1), ...)^T$ is a vector comprising the input signal samples $x(n)$.

The non-linear terms may cause unwanted distortions of the output signal y.

In order to counteract these distortions, the equalizer module 14 is configured to equalize the output signal y, e.g. pre-distort a signal processed, such that the unwanted distortions are removed from the output signal y.

For this purpose, the equalizer module 14 comprises a Volterra filter module 16 with filter coefficients that are adapted to remove the unwanted perturbations from the output signal y.

The functionality of the Volterra filter module 16 will be described in more detail hereinafter.

Figure 2 schematically shows a second variant of the electronic device 10, wherein the electronic device 10 is established as a signal generator.

For example, the electronic device 10 may be established as an arbitrary signal generator.

Accordingly, the non-linear electronic component 12 may be established as any component being configured to generate a predetermined output signal *y* or to convert a digital input signal *x* to an analog output signal *y*.

The electronic device 10 comprises a control module 18 that is configured to generate the input signal *x,* wherein the input signal *x* comprises instructions for the electronic component 12 to generate the output signal *y.*

The equalizer module 14 may be interconnected between the control module 18 and the non-linear electronic component 12.

Accordingly, the equalizer module 14 or rather the Volterra filter module 16 is configured to adapt the input signal x such that the output signal y does not comprise any non-linear distortions.

In other words, the Volterra filter module 16 is configured to pre-compensate, also called pre-distort, the non-linear distortions that would be caused by the non-linear electronic component 12.

Alternatively, the electronic device 10 of Figure 2 may be established as a digital-to-analog converter.

Accordingly, the equalizer module 14 or rather the Volterra filter module 16 is configured to adapt the digital input signal x such that the analog output signal y does not comprise any non-linear distortions.

In other words, the Volterra filter module 16 is configured to pre-compensate the non-linear distortions that would be caused by the non-linear electronic component 12.

The equalizer module 14 needs to be properly calibrated, i.e. the filter coefficients of the Volterra filter module 16 need to be properly set, such that the Volterra filter module 16 correctly equalizes the output signal y.

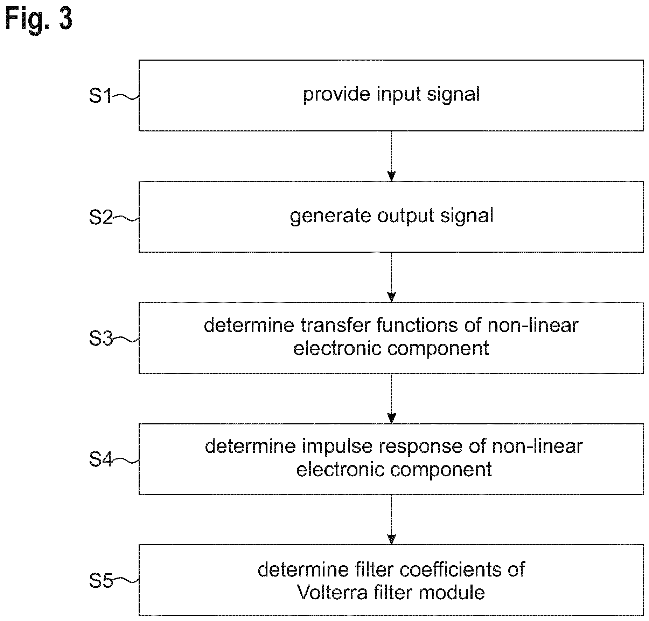

The correct filter coefficients for the Volterra filter module can be obtained by a method for determining filter coefficients of the equalizer module 14. The method is described in the following with reference to Figure 3.

Without restriction of generality, the method is described in the following in the context of the electronic device 10 of Figure 1. However, it is to be understood that the method can readily be adjusted for the electronic device 10 of Figure 2.

An input signal x is provided (step S1).

In general, the input signal x is a calibration signal that is used in order to calibrate the equalizer module 14.

Accordingly, the input signal x may have known properties, i.e. a known spectrum, known amplitudes and/or known phases.

The input signal x may be received from an external electronic device, for example from a signal generator or from a device under test.

Alternatively, the input signal $x$ may be generated by another internal electronic component of the electronic device 10.

The input signal $x$ is processed by means of the non-linear electronic component 12, thereby generating the output signal $y$ (step S2).

A first mathematical model is provided, wherein the first mathematical model describes the non-linear electronic component 12 in terms of a first Volterra series.

In general, Volterra series can be used in order to describe non-linear systems that are frequency-dependent and independent of a signal level. The output signal y can then be written in terms of the input signal $x$ as follows:

$$y(t/T_a) = \sum_{m=1}^{M} y_m(t/T_a) = \sum_{m=1}^{M} \sum_{\mu_0=0}^{L_{m,0}-1} \dots \sum_{\mu_{m-1}=0}^{L_{m,m-1}-1} h_m(\mu_0, \dots, \mu_{m-1}) \cdot \prod_{\alpha=0}^{m-1} x(t/T_a - \mu_\alpha)$$

$$(E.1)$$

Therein, $M$ is the maximum order of the Volterra series, $h_m(\mu_0, \dots)$ are multi-dimensional impulse responses, and $L_{m,\mu}$ is the length of the impulse response for the dimension $\mu$ and for the order m.

In other words, the non-linear electronic component 12 can be described as a Volterra filter, and may also be called Volterra system, wherein $L_{m,\mu}$ is the length of the Volterra filter of order $m$ for the dimension $\mu$. This interpretation will be used in the following.

The filter coefficients $h_m(t_0/T_a, \dots, t_{m-1}/T_a)$ of the Volterra system are ambiguous, as multiple filter coefficients lead to the same product signal

$$x(t_0/T_a, \dots, t_{m-1}/T_a) = \prod_{\alpha=0}^{m-1} x(t_\alpha/T_a)$$

$$(E.2)$$

in equation (E.1). Therein, $T_a$ is the sampling time associated with the input signal $x$, i.e. $f_a = 1/T_a$ is the sampling frequency of the input signal $x$.

For example, the filter coefficients

$$\{h_2(t_0/T_a, t_1/T_a), h_2(t_1/T_a, t_0/T_a)\}$$

$$(E.3)$$

of a Volterra system of order $m = 2$ yield the same product signal $x(t_0/T_a, t_1/T_a)$. Likewise, the following filter coefficients of a Volterra system of order $m = 3$ yield the same product signal $x(t_0/T_a, t_1/T_a, t_2/T_a)$:

$$\{h_3(t_0/T_a, t_1/T_a, t_2/T_a), h_3(t_2/T_a, t_0/T_a, t_1/T_a), h_3(t_1/T_a, t_2/T_a, t_0/T_a), h_3(t_2/T_a, t_1/T_a, t_0/T_a), h_3(t_1/T_a, t_0/T_a, t_2/T_a), h_3(t_0/T_a, t_2/T_a, t_1/T_a), \}$$

$$(E.4)$$

Accordingly, there is a certain freedom of choice when describing the non-linear electronic component 12 in terms of the Volterra series of equation (E.1).

Particularly, the ambiguous filter coefficients $h_m$ may be chosen such that only one coefficient of a set of ambiguous coefficients is non-zero. Alternatively, the ambiguous filter coefficients may be chosen to be all equal to each other, such that a transfer function of the Volterra system has an additional symmetry.

The Fourier transform of equation (E.1) yields the spectrum $Y$ of the output signal $y$:

$$Y(f/f_a) = \sum_{m=1}^{M} Y_m(f/f_a)$$

$$= \sum_{m=1}^{M} \sum_{f_0/f_a=0}^{N-1} \cdots \sum_{f_{m-1}/f_a=0}^{N-1} H_m(f_0/f_a, \ldots, f_{m-1}/f_a) \cdot \prod_{\alpha=0}^{m-1} X(f_\alpha/f_a) \cdot \delta_1(f/f_a - f_0/f_a - \cdots - f_{m-1}/f_a)$$

$$(E.5)$$

Therein,

$$X(f/f_a) = \sum_{t/T_a=0}^{N-1} x(t/T_a) \cdot e^{-j \cdot 2\pi \cdot t/T_a \cdot f/f_a}$$

$$(E.6)$$

is the spectrum of the input signal x, and

$$H_m(f_0/f_a, \ldots, f_{m-1}/f_a) = \sum_{t_0/T_a=0}^{N-1} \cdots \sum_{t_{m-1}/T_a=0}^{N-1} h_m(t_0/T_a, \ldots, t_{m-1}/T_a) \cdot e^{-j \cdot 2\pi \cdot (t_0/T_a \cdot f_0/f_a + \cdots + t_{m-1}/T_a \cdot f_{m-1}/f_a)}$$

$$(E.7)$$

is the transfer function of the Volterra system, i.e. the transfer function of the non-linear electronic component 12.

Moreover, $N$ is the length of the Fourier transform, and $\delta_1(f/f_a)$ is a Kronecker-delta-operator, which operates with respect to its argument modulo 1:

$$\delta_1(f/f_a) = \delta(mod\{f/f_a, 1\}).$$

$$(E.8)$$

Transfer functions of real-valued Volterra systems have a complex conjugate symmetry:

$$H_m(-f_0/f_a, \ldots, -f_{m-1}/f_a) = H_m^*(f_0/f_a, \ldots, f_{m-1}/f_a).$$

$$(E.9)$$

If the impulse responses $h_m(t_0/T_a, \ldots, t_{m-1}/T_a)$ are symmetric, then transfer functions of Volterra systems of order $m = 2$ have the additional symmetry

$$H_2(f_0/f_a, f_1/f_a) = H_2(f_1/f_a, f_0/f_a)$$

$$(E.10)$$

while the transfer functions of Volterra systems of order $m = 3$ have the additional symmetry

$$H_3(f_0/f_a, f_1/f_a, f_2/f_a) = H_3(f_2/f_a, f_0/f_a, f_1/f_a) = H_3(f_1/f_a, f_2/f_a, f_0/f_a) = H_3(f_2/f_a, f_1/f_a, f_0/f_a)$$
$$= H_3(f_1/f_a, f_0/f_a, f_2/f_a) = H_3(f_0/f_a, f_2/f_a, f_1/f_a)$$

$$(E.11)$$

In other words, the transfer functions are equal to each other at points where the individual frequencies $f_\mu/f_a$ are interchanged arbitrarily.

From equation (E.5) it can be seen that the sampling rate $f_a$ associated with the input signal $x$ is sufficient to characterize the non-linear electronic component 12 as a Volterra system. Accordingly, the sampling rate does not need to be enhanced, e.g. via an interpolation.

If the input signal $x$ is established as a multi-frequency signal comprising a number $N_T$ of different signal components having different predefined frequencies $f_n/f_a$, amplitudes $A_\mu$ and phases $\phi_\mu$, the input signal can be written as

$$X(f/f_a) = \sum_{\mu=0}^{N_T-1} A_\mu \cdot e^{j\phi_\mu} \cdot \left[\delta_1(f/f_a - f_\mu/f_a) + \delta_1(f/f_a + f_\mu/f_a)\right]$$

$$(E.12)$$

In this case, the output signal spectrum Y is given by

$$Y_m(f/f_a) = \sum_{\mu_0=0}^{N_T-1} \cdots \sum_{\mu_{m-1}=0}^{N_T-1} H_m\left(\frac{f_{\mu_0}}{f_a}, \ldots, \frac{f_{\mu_{m-1}}}{f_a}\right) \cdot \prod_{\alpha=0}^{m-1} A_{\mu_\alpha} \cdot e^{j\sum_{\alpha=1}^{m} \phi_{\mu_\alpha}} \cdot \left[\delta_1\left(\frac{f}{f_a} - \sum_{\alpha=0}^{m-1}\frac{f_{\mu_\alpha}}{f_a}\right) + \delta_1\left(\frac{f}{f_a} + \sum_{\alpha=0}^{m-1}\frac{f_{\mu_\alpha}}{f_a}\right)\right] \cdot$$

$$(E.13)$$

It is noted that the multi-dimensional impulse responses of some Volterra systems, for example of low-noise amplifiers, are weakly occupied, i.e. most of the components of the multi-dimensional impulse responses are equal to zero.

If only filter coefficients of the main diagonal of the impulse responses are non-zero, the Volterra series may also be called a "memory polynomial". If only few diagonals of the impulse responses are non-zero, the Volterra series may also be called an "extended memory polynomial":

$$y(t/T_a) = \sum_{m=1}^{M} y_m(t/T_a) = \sum_{m=1}^{M} \sum_{\mu_0=0}^{L-1} \sum_{\mu_1=\mu_0-D_{m,1}}^{\mu_0+D_{m,1}} \cdots \sum_{\mu_{m-1}=\mu_0-D_{m-1,m-1}}^{\mu_0+D_{m-1,m-1}} h_m(\mu_0, \ldots, \mu_{m-1}) \cdot \prod_{\alpha=0}^{m-1} x(t/T_a - \mu_\alpha) \cdot$$

$$(E.14)$$

Therein, the term $2D_{m,\mu} + 1$ describes the number of diagonals of the impulse response of the Volterra system of order $m$ with respect to dimension $\mu$.

Based on the input signal $x$, the output signal $y$, and the first Volterra series, impulse responses and/or transfer functions of the non-linear electronic component 12 are determined (step S3).

In the following, two different variants are described with respect to the input signal that both allow for determining the impulse responses and/or transfer functions of the non-linear electronic component 12.

It has turned out that restricting the analysis to the order $M = 3$ is sufficient in both variants.

According to a first variant, the input signal x may be established as a broad-band noise signal.

Equation (E.1) can be rewritten in a matrix-vector-notation as follows:

$$\underline{y}(t/T_a) = \underline{\underline{X}}(t/T_a) \cdot \underline{h}.$$

(E.15)

The vector

$$\underline{h} = \left[h_1(0), \ldots, h_1(L_1 - 1), h_2(0,0), \ldots, h_2(L_{2,0} - 1, L_{2,1} - 1), h_3(0,0,0), \ldots, h_3(L_{3,0} - 1, L_{3,1} - 1, L_{3,2} - 1)\right]^T$$

(E.16)

comprises all filter coefficients of the impulse responses of order $m = 1,2,3$, wherein only one filter coefficient of each set of ambiguous filter coefficients is taken into account.

The matrix

$$\underline{\underline{X}}(t/T_a) = \begin{bmatrix} \underline{x}^T(t/T_a) \\ \vdots \\ \underline{x}^T(t/T_a - N + 1) \end{bmatrix}$$

(E.17)

comprises vectors

$$\underline{x}(t/T_a) = \left[x(t/T_a), \ldots, x(t/T_a - L_1 - 1), x(t/T_a) \cdot x(t/T_a), \ldots, x(t/T_a - L_{2,0} + 1) \cdot x(t/T_a - L_{2,1} + 1), x(t/T_a)\right.$$
$$\left. \cdot x(t/T_a) \cdot x(t/T_a), \ldots, x(t/T_a - L_{3,0} + 1) \cdot x(t/T_a - L_{3,1} + 1) \cdot x(t/T_a - L_{3,0} + 1)\right]^T,$$

(E.18)

that comprise the corresponding product signals of the filter coefficients. The vector

$$\underline{y}(t/T_a) = \left[y(t/T_a), \ldots, y(t/T_a - N + 1)\right]^T$$

(E.19)

comprises the sample points of the output signal $y$ of the non-linear electronic component 12.

In order to determine the impulse responses and/or transfer functions of the non-linear electronic component 12, a cost functional $K$ is provided, wherein the cost functional K describes a mean error signal power:

$$K = \overline{e}^2(t/T_a) = \left[\underline{\underline{X}}(t/T_a) \cdot \underline{h} - \underline{y}(t/T_a)\right]^T \cdot \left[\underline{\underline{X}}(t/T_a) \cdot \underline{h} - \underline{y}(t/T_a)\right].$$

(E.20)

The cost functional is minimized by the following choice of filter coefficients:

$$\underline{h} = \left[\underline{\underline{X}}^{T}(t/T_a) \cdot \underline{\underline{X}}(t/T_a)\right]^{-1} \cdot \left[\underline{\underline{X}}^{T}(t/T_a) \cdot \underline{y}(t/T_a)\right]$$

(E.21)

It is noted that the correlation matrix

$$\underline{\underline{C}}(t/T_a) = \left[\underline{\underline{X}}^{T}(t/T_a) \cdot \underline{\underline{X}}(t/T_a)\right]$$

(E.22)

needs to be inverted in order to determine the filter coefficients according to equation (E.21).

A broad-band noise signal comprises a lot of different frequencies. As can be seen in equation (E.13), several different signal components having different frequencies contribute to the same output signal frequency. In other words, there is a superposition of contributions from different input signal frequencies contributing to the same output signal frequency.

Such superpositions can occur within the same order $m$ of the Volterra system and/or across different orders $m$ of the Volterra system.

For example, within the order $m = 2$, all frequencies $\{-f_{in}/f_a, +f_{in}/f_a\}$ always superpose to give an output frequency of zero. Within the order $m = 3$, the input frequencies $\{-f_{in,0}/f_a, +f_{in,0}/f_a, +f_{in,1}/f_a\}$ always yield an output frequency $f_{out}/f_a = f_{in,1}/f_a$.

An example for such superpositions between different orders are input frequencies $\{0.15, 0.15\}$ for $m = 2$ and $\{0.1, 0.1, 0.1\}$ for $m = 3$, which both yield an output frequency of $f_{out}/f_a = 0.3$.

Thus, using a broad-band noise signal as input signal $x$ leads to a systematically overdetermined computation problem.

It has turned out that that the correlation matrix defined in equation (E.22) has a rather high condition, i.e. a high amplification factor of errors, which further complicates the matrix inversion.

Moreover, the correlation matrix comprises expectation values of higher order, namely

$$r_x^o(T_0/T_a, T_1/T_a, \ldots, T_{o-1}/T_a) = E\left\{\prod_{\mu=0}^{o-1} x(t/T_a - T_\mu/T_a)\right\}.$$

(E.23)

More precisely, depending on the maximum order $M$ of the Volterra system, the correlation matrix comprises expectation values of the orders

$$o = \{2, 3, \ldots, 2M\}$$

(E.24)

These problems can be counteracted by enhancing the numeric precision for the matrix inversion and/or by enhancing the observation length $N$ for determining the correlation matrix. However, this may considerably increase the necessary computation time.

According to a second variant, the input signal $x$ may be established as a multi-frequency signal comprising a pre-defined number $N_T$ of signal components having different frequencies.

The output signal of the Volterra system then comprises spectral components having output frequencies

$$f_{out,\alpha}/f_a = mod\left\{\sum_{\mu=0}^{m-1} f_{in,\mu,\alpha}/f_a, 1\right\},$$

(E.25)

which are generated by groups of $m$ input frequencies $\{f_{in,0,\alpha}/f_a, ..., f_{in,m-1,\alpha}/f_a\}$, wherein frequencies within a group $\alpha$ may be partially or completely the same.

If the amplitudes and phases of the input signal x are known and the amplitudes and phases of the output signal y are determined, the transfer functions $H_m(\{f_{in,0,\alpha}/f_a, ..., f_{in,m-1,\alpha}/f_a\})$ can be determined at the spectral positions $\{f_{in,0,\alpha}/f_a, f_{in,m-1,\alpha}/f_a\}$ of the frequency group $\alpha$.

As described above in the context of the input signal being established as a broad-band noise signal, different groups of input frequencies can contribute to the same output frequency.

Accordingly, several contributions associated with different transfer functions superpose, and the transfer functions may not be determinable at these spectral positions.

It has turned out that there are different classes of such ambiguities, namely

- the ambiguities originate within a single order $m$ of the Volterra system;
- the ambiguities originate across different orders $m$ of the Volterra system;
- the ambiguities are systematic, i.e. they cannot be avoided by choosing another set of input frequencies; and
- the ambiguities are non-systematic, i.e. they can be avoided by choosing another set of input frequencies.

Accordingly, the input frequencies of the input signal x are chosen such that only the systematic ambiguities remain and there are no non-systematic ambiguities. The correct input frequencies can, for example, be found by solving a corresponding optimization problem with an intelligent search technique.

It is noted that in order to fully characterize a Volterra system of maximum order $M = 3$, a minimum number $N_T = 3$ of different signal components having different frequencies is required.

The transfer functions $H_m$ of the Volterra system (i.e. of the non-linear electronic component 12)

$$H_m\left(\frac{f_0}{f_a}, ..., \frac{f_{m-1}}{f_a}\right) = \frac{c(m)}{N_{comb}(m, f_0/f_a, ..., f_{m-1}/f_a)} \cdot \frac{A_{out}(f_{out}/f_a)}{\prod_{\mu=0}^{m-1} A_{in}(f_\mu/f_a)} \cdot e^{j\cdot\phi_{out}(f_{out}/f_a)-j\cdot\sum_{\mu=0}^{m-1}\phi_{in}(f_\mu/f_a)}$$

(E.26)

at the spectral positions $\{f_0/f_a, ... ,f_{m-1}/f_a\}$ depend on the amplitude $A_{out}(f_{out}/f_a)$ and the phase $\phi_{out}(f_{out}/f_a)$ of the output signal that are associated with the input frequencies $\{f_0/f_a, ...,f_{m-1}/f_a\}$.

Moreover, the transfer functions $H_m$ depend on the amplitudes $A_{in}(f_\mu/f_a)$ and the phases $\phi_{in}(f_\mu/f_a)$ of the components of the input signal x.

In equation (E.26), the factor $c(m)$ is a scaling factor that depends on the order $m$, wherein $c(1) = 1$, $c(2) = 2$, and $c(3) = 4$.

The factor $N_{comb}$ is a combinatorial factor, wherein:

- $N_{comb}(m = 1) = 1$;
- $N_{omb}(m = 2, f_0/f_a, f_1/f_a)$ is equal to 1 if $f_0 = f_1$ and is equal to 2 otherwise; and
- $N_{comb}(m = 3, f_0/f_a, f_1/f_a, f_2/f_a)$ is equal to 1 if all frequencies are identical, equal to 3 if two frequencies are identical, and equal to 6 if all frequencies are different from each other.

It has turned out that the transfer functions $H_m$ determined according to equation (E.26) are symmetric, and the associated impulse responses $h_m$ are axisymmetric.

Put differently, the transfer functions $H_m$ are sampled with the multi-frequency input signal x.

Preferably, the individual signal components of the input signal x are non-equidistant in frequency domain, i.e. the value of $f_i - f_j$ is different for each pair of frequencies $f_i$, $f_j$ of the input signal.

In order to determine the transfer functions $H_m$ according to equation (E.26), the amplitudes $A_\mu$ and phases $\phi_\mu$ of the output signal y have to be determined.

The output signal $y$ can be written as

$$y(t/T_a) = \sum_{\mu=0}^{N_T-1} A_\mu \cdot \sin(2\pi \cdot f_\mu/f_a \cdot t/T_a + \phi_\mu) = \sum_{\mu=0}^{N_T-1} C_\mu \cdot \sin(2\pi \cdot f_\mu/f_a \cdot t/T_a) + D_\mu \cdot \cos(2\pi \cdot f_\mu/f_a \cdot t/T_a)$$

(E.27)

Equation (E.27) can be re-written in matrix-vector-notation as follows:

$$\underline{y}(t/T_a) = \underline{\underline{X}}(t/T_a) \cdot \underline{h}.$$

(E.28)

The vector

$$\underline{h} = \left[ C_0, D_0, C_1, D_1, \dots, C_{N_T-1}, D_{N_T-1} \right]^T$$

(E.29)

comprises all amplitudes of the sine terms and of the cosine terms in equation (E.27). The matrix

$$\underline{\underline{X}}(t/T_a) = \begin{bmatrix} \underline{x}^T(t/T_a) \\ \vdots \\ \underline{x}^T(t/T_a - N + 1) \end{bmatrix}$$

(E.30)

comprises the vectors

$$\underline{x}(t/T_a) = \left[ \sin(2\pi \cdot f_0/f_a \cdot t/T_a), \cos(2\pi \cdot f_0/f_a \cdot t/T_a), \dots, \sin(2\pi \cdot f_{N_T-1}/f_a \cdot t/T_a), \cos(2\pi \cdot f_{N_T-1}/f_a \cdot t/T_a) \right]^T,$$

(E.31)

which comprise the sample points associated with the sine terms and the cosine terms. $N$ is the number of samples that is used for determining the amplitudes and phases.

The vector

$$\underline{y}(t/T_a) = \left[ y(t/T_a), \dots, y(t/T_a - N + 1) \right]^T$$

(E.32)

comprises the samples of the output signal $y$.

In order to determine the amplitudes $C_\mu$ and $D_\mu$, a cost functional $K$ is provided, wherein the cost functional $K$ describes a mean error signal power:

$$K = \vec{e}^{2}(t/T_a) = \left[\underline{\underline{X}}(t/T_a) \cdot \underline{h} - \underline{y}(t/T_a)\right]^{T} \cdot \left[\underline{\underline{X}}(t/T_a) \cdot \underline{h} - \underline{y}(t/T_a)\right].$$

(E.33)

The cost functional is minimized by the following amplitude vector:

$$\underline{h} = \left[\underline{\underline{X}}^{T}(t/T_a) \cdot \underline{\underline{X}}(t/T_a)\right]^{-1} \cdot \left[\underline{\underline{X}}^{T}(t/T_a) \cdot \underline{y}(t/T_a)\right]$$

(E.34)

The inverse of the correlation matrix

$$\underline{\underline{X}}^{T}(t/T_a) \cdot \underline{\underline{X}}(t/T_a)$$

(E.35)

can be determined a priori, and may be saved in a memory for later usage.

The phases $\phi_\mu$ can then be determined from the equation

$$\phi_\mu = \operatorname{atan}(D_\mu/C_\mu)$$

(E.36)

The amplitudes $A_\mu$ can then be determined according to the equation

$$A_\mu = C_\mu/\sin(\phi_\mu)$$

(E.37)

There are two special cases at $f/f_a = 0$ and $f/f_a = -1/2$. In these cases, only the amplitude $A_\mu$ has to be determined. Thus, in these cases the parameter $D_\mu$ has to be set to zero in equations (E.27) and (E.29).

Optionally, the impulse responses $h_m$ of the non-linear electronic component 12 may be determined based on the determined transfer functions $H_m$ (step S4).

Equation (E.7) can be reformulated in matrix-vector notation as follows:

$$\underline{y} = \underline{\underline{X}} \cdot \underline{h}.$$

(E.38)

The vector

**13**

$$\underline{h} = [h_m(0, \dots, 0), \dots, h_m(L_m - 1, \dots, L_m - 1)]^T$$

(E.39)

comprises all impulse responses of the non-linear electronic component 12 (the impulse responses may also be called filter coefficients of the Volterra system representing the non-linear electronic component 12). The reference vector

$$\underline{y} = [H_m(f_0/f_a, \dots, f_0/f_a), \dots, H_m(f_{N-1}/f_a, \dots, f_{N-1}/f_a)]^T$$

(E.40)

comprises the transfer functions $H_m$ of the non-linear electronic component 12, i.e. of the Volterra system. The matrix

$$X = \begin{bmatrix} \underline{x}^T(f_0/f_a, \dots, f_0/f_a) \\ \vdots \\ \underline{x}^T(f_{N-1}/f_a, \dots, f_{N-1}/f_a) \end{bmatrix}$$

(E.41)

comprises vectors

$$\underline{x}(f_0/f_a, \dots, f_{m-1}/f_a) = \left[ e^{-j \cdot 2\pi \cdot [f_0/f_a \cdot 0 + \dots + f_{m-1}/f_a \cdot 0]}, \dots, e^{-j \cdot 2\pi \cdot [f_0/f_a \cdot (L_m - 1) + \dots + f_{m-1}/f_a \cdot (L_m - 1)]} \right]^T,$$

(E.42)

that comprise the exponential functions of the respective Fourier transforms.

The following cost functional $K$ is provided, wherein the cost functional $K$ describes a mean spectral error signal power:

$$K = \overline{E}^2 = \left[ \underline{X} \cdot \underline{h} - \underline{y} \right]^T \cdot diag\{\underline{W}\} \cdot \left[ \underline{X} \cdot \underline{h} - \underline{y} \right].$$

(E.43)

Therein, the vector

$$\underline{W} = [W(f_0/f_a, \dots, f_0/f_a), \dots, W(f_{N-1}/f_a, \dots, f_{N-1}/f_a)]^T$$

(E.44)

is a spectral weighting function. Via the spectral weighting function, the spectral quality of the Volterra system can be controlled.

The cost functional $K$ is minimized by the following filter coefficients (i.e. impulse responses) of the Volterra system:

$$\underline{h} = \left[ diag\{\underline{W}\} \cdot \underline{\underline{X}}^T \cdot \underline{\underline{X}} \right]^{-1} \cdot \left[ diag\{\underline{W}\} \cdot \underline{\underline{X}}^T \cdot \underline{y} \right]$$

(E.45)

It has turned out that the minimization problem defined by equations (E.38) to (E.45) is not ambiguous, and that the correlation matrix

$$diag\{\underline{W}\} \cdot \underline{\underline{X}}^T \cdot \underline{\underline{X}}$$

(E.46)

only has a small or moderate condition.

The inverse of the correlation matrix can be determined a priori, and may be saved in a memory for later usage.

The transfer functions $H_m$ do not have to be sampled in an equidistant manner. However, the maximum frequency distance puts an upper boundary on the length $L_m$ of the impulse response $h_m(t_0/T_a, ..., t_{m-1}/T_a)$:

$$L_m \leq \frac{1}{\max_{\mu,\nu}\{|f_\mu/f_a - f_\nu/f_a|\}}$$

(E.47)

It is noted that the minimization technique described in equations (E.38) to (E.47) can also be used for memory polynomials or otherwise pruned Volterra series. In that case, the impulse responses that are equal to zero have to be deleted from equation (E.39).

Filter coefficients of the Volterra filter module 16 are determined based on the determined transfer functions $H_m$ of the non-linear electronic component 12 (step S5).

More precisely, the filter coefficients of the Volterra filter module 16 are determined by means of a Pth order inverse technique, as will be described in more detail below.

In general, the Volterra filter module 16 is described by means of a second mathematical model, more precisely by means of a second Volterra series, analogously to equation (E.1).

First, the Pth order inverse technique will be described in time domain.

The filter coefficients $h_{eq,1}$ of order $m = 1$ of the Volterra filter module 16 are defined by the following equation:

$$y(k) = \sum_{\mu_0} h_{eq,1}(\mu_0) \cdot \sum_{\alpha_0} h_1(\alpha_0) \cdot x(k - \mu_0 - \alpha_0) = x(k).$$

(E.48)

Therein, $h_m(k_0, k_1,..., k_{m-1})$ are the impulse responses of the Volterra system (i.e. of the non-linear electronic system 12) that have already been determined, while $h_{eq,m}$ are the desired impulse responses, i.e. the filter coefficients of the Volterra filter module 16.

In order for the output signal $y(k)$ of the equalizer module 14 to be equal to the input signal $x(k)$ of the non-linear electronic component 12, the condition

$$\sum_{\mu_0} h_{eq,1}(\mu_0) \cdot h_1(-\mu_0) = 1$$

$$(E.49)$$

has to be fulfilled for $\mu_0 + \alpha_0 = 0$, while the condition

$$\sum_{\mu_0} h_{eq,1}(\mu_0) \cdot h_1(D - \mu_0) = 0$$

$$(E.50)$$

has to be fulfilled for $\mu_0 + \alpha_0 = D \neq 0$. Equations (E.49) and (E.50) define a system of equations that can be solved by means of a minimum square error technique.

For the second order, i.e. $m = 2$, the following condition has to be fulfilled:

$$\sum_{\mu_0} \sum_{\mu_1} h_{eq,2}(\mu_0, \mu_1) \cdot x(k - \mu_0) \cdot x(k - \mu_1) = -\sum_{\alpha_0} h_{eq,1}(\alpha_0) \sum_{\beta_0} \sum_{\beta_1} h_2(\beta_0, \beta_1)$$
$$\cdot \left[ \sum_{\gamma_0} h_{eq,1}(\gamma_0) \cdot x(k - \alpha_0 - \beta_0 - \gamma_0) \right] \cdot \left[ \sum_{\gamma_1} h_{eq,1}(\gamma_1) \cdot x(k - \alpha_0 - \beta_1 - \gamma_1) \right].$$

$$(E.51)$$

This leads to the following expression for the second order filter coefficients of the Volterra filter module 16:

$$h_{eq,2}(\mu_0, \mu_1) = -\sum_{\alpha_0} h_{eq,1}(\alpha_0) \cdot \sum_{\beta_0} \sum_{\beta_1} h_2(\beta_0, \beta_1) \cdot h_{eq,1}(\mu_0 - \alpha_0 - \beta_0) \cdot h_{eq,1}(\mu_1 - \alpha_0 - \beta_1).$$

$$(E.52)$$

For the third order, i.e. $m = 3$, the condition is that there should be no distortions of order $m = 3$ at the output of the Volterra filter module 16. In a shortened notation, this condition can be expressed as

$$Q_3 = K_1 H_3 + K_2[H_1 + H_2] - K_2 H_1 - K_2 H_2 + K_3 H_1 = 0$$

$$(E.53)$$

wherein $K_m$ represents the Volterra filter module 16 at order $m$, and wherein $H_m$ represents the Volterra system (i.e. the non-linear electronic component 12) at order $m$.

$K_1$ and $K_2$ have already been determined above, cf. equations (E.50) and (E.52).

The third order contribution of the Volterra filter module 16 is then given by

$$K_3 = -K_1 H_3 K_1 - K_2 [H_1 + H_2] K_1 + K_2 H_1 K_1 + K_2 H_2 K_1 = -K_1 H_3 K_1 - K_2 [H_1 + H_2] K_1 + K_2 + K_2 H_2 K_1$$
$$= T_{(1)} + T_{(2)} + T_{(3)} + T_{(4)}.$$

$$(\text{E.54})$$

In the following, the explicit expressions for the terms $T_{(\mu)}$ are given:

$$T_{(1)} = -\sum_{\alpha_0} h_{eq,1}(\alpha_0) \cdot \sum_{\beta_0} \sum_{\beta_1} \sum_{\beta_2} h_3(\beta_0, \beta_1, \beta_2)$$
$$\cdot \left[\sum_{\gamma_0} h_{eq,1}(\gamma_0) \cdot x(k - \alpha_0 - \beta_0 - \gamma_0)\right] \cdot \left[\sum_{\gamma_1} h_{eq,1}(\gamma_1) \cdot x(k - \alpha_0 - \beta_1 - \gamma_1)\right] \cdot \left[\sum_{\gamma_2} h_{eq,1}(\gamma_2) \cdot x(k - \alpha_0 - \beta_2 - \gamma_2)\right],$$

$$T_{(2)} = -\sum_{\alpha_0} \sum_{\alpha_1} h_{eq,2}(\alpha_0, \alpha_1) \cdot \left[x(k - \alpha_0) + T_{(5)}\right] \cdot \left[x(k - \alpha_1) + T_{(6)}\right]$$

$$T_{(5)} = \sum_{\beta_0} \sum_{\beta_1} h_2(\beta_0, \beta_1) \cdot \left[\sum_{\gamma_0} h_{eq,1}(\gamma_0) \cdot x(k - \alpha_0 - \beta_0 - \gamma_0)\right] \cdot \left[\sum_{\gamma_1} h_{eq,1}(\gamma_0) \cdot x(k - \alpha_0 - \beta_1 - \gamma_1)\right]$$

$$T_{(6)} = \sum_{\beta_2} \sum_{\beta_3} h_2(\beta_2, \beta_3) \cdot \left[\sum_{\gamma_2} h_{eq,1}(\gamma_2) \cdot x(k - \alpha_1 - \beta_2 - \gamma_2)\right] \cdot \left[\sum_{\gamma_3} h_{eq,1}(\gamma_0) \cdot x(k - \alpha_1 - \beta_3 - \gamma_3)\right]$$

$$T_{(3)} = +\sum_{\alpha_0} \sum_{\alpha_1} h_{eq,2}(\alpha_0, \alpha_1) \cdot x(k - \alpha_0) \cdot x(k - \alpha_1)$$

$$T_{(4)} = +\sum_{\alpha_0} \sum_{\alpha_1} h_{eq,2}(\alpha_0, \alpha_1)$$
$$\cdot \left[\sum_{\beta_0} \sum_{\beta_1} h_2(\beta_0, \beta_1) \cdot \left\{\sum_{\gamma_0} h_{eq,1}(\gamma_0) \cdot x(k - \alpha_0 - \beta_0 - \gamma_0)\right\} \cdot \left\{\sum_{\gamma_1} h_{eq,1}(\gamma_1) \cdot x(k - \alpha_0 - \beta_1 - \gamma_1)\right\}\right]$$
$$\cdot \left[\sum_{\beta_2} \sum_{\beta_3} h_2(\beta_2, \beta_3) \cdot \left\{\sum_{\gamma_2} h_{eq,1}(\gamma_0) \cdot x(k - \alpha_1 - \beta_2 - \gamma_2)\right\} \cdot \left\{\sum_{\gamma_3} h_{eq,1}(\gamma_3) \cdot x(k - \alpha_1 - \beta_3 - \gamma_3)\right\}\right].$$

$$(\text{E.55})$$

For the calculation of the impulse response $h_{eq,3}$ of the third order of the Volterra filter module 16, only product signals $x(k_0) \cdot x(k_1) \cdot x(k_2)$ with three sample values may contribute. It has turned out that terms that do not meet this condition completely cancel each other.

Accordingly, it holds

$$-\sum_{\alpha_0}\sum_{\alpha_1} h_{eq,2}(\alpha_0,\alpha_1)\cdot T_{(5)}\cdot T_{(6)} = -T_{(4)}$$

$$-\sum_{\alpha_0}\sum_{\alpha_1} h_{eq,2}(\alpha_0,\alpha_1)\cdot x(k-\alpha_0)\cdot x(k-\alpha_1) = -T_{(3)}.$$

(E.56)

The result for the third order filter coefficients of the Volterra filter module 16 has two contributions, namely $h_{eq,3}^{(1)}$ and $h_{eq,3}^{(2)}$, which are given by

$$h_{eq,3}^{(1)}(\mu_0,\mu_1,\mu_2) = -\sum_{\alpha_0} h_{eq,1}(\alpha_0)$$

$$\cdot \sum_{\beta_0}\sum_{\beta_1}\sum_{\beta_2} h_3(\beta_0,\beta_1,\beta_2)\cdot h_{eq,1}(\mu_0-\alpha_0-\beta_0)\cdot h_{eq,1}(\mu_1-\alpha_0-\beta_1)\cdot h_{eq,1}(\mu_2-\alpha_0-\beta_2)$$

$$h_{eq,3}^{(2)}(\mu_0,\mu_1,\mu_2) = -\sum_{\alpha_1}^{L_{eq,1}} h_{eq,2}(\mu_0,\alpha_1)\cdot \sum_{\beta_2}\sum_{\beta_3} h_2(\beta_2,\beta_3)\cdot h_{eq,1}(\mu_1-\alpha_1-\beta_2)\cdot h_{eq,1}(\mu_2-\alpha_1-\beta_3)$$

$$-\sum_{\alpha_0}^{L_{eq,1}-1} h_{eq,2}(\alpha_0,\mu_2)\cdot \sum_{\beta_0}\sum_{\beta_1} h_2(\beta_0,\beta_1)\cdot h_{eq,1}(\mu_0-\alpha_0-\beta_0)\cdot h_{eq,1}(\mu_1-\alpha_0-\beta_1).$$

(E.57)

The third order filter coefficients of the Volterra filter module 16 are then given by

$$h_{eq,3}(\mu_0,\mu_1,\mu_2) = h_{eq,3}^{(1)}(\mu_0,\mu_1,\mu_2) + h_{eq,3}^{(2)}(\mu_0,\mu_1,\mu_2)$$

(E.58)

With the same technique, filter coefficients $h_{eq,m}(k_0,k_1,k_2)$ of extended memory polynomials or pruned impulse responses can be determined. In this case, only sample times lying on the diagonals of the impulse responses $h_{eq,m}(k_0,k_1,k_2)$ are considered.

The determined impulse responses $h_{eq,m}(k_0,k_1,k_2)$ may not be the final filter coefficients for the Volterra filter module 16. Instead, the determined impulse responses $h_{eq,m}(k_0,k_1,k_2)$ may serve as reference impulse responses $h_{eq,ref,m}(k_0,k_1,k_2)$ for determining the final filter coefficients of the Volterra filter module 16, as will be described in more detail below.

Alternatively to the time-domain technique described above, the filter coefficients of the Volterra filter module 16 can also be determined by a Pth order inverse technique in frequency domain.

First, equation (E.5) is formulated for the maximum order $M = 3$, and the innermost summation is performed, resulting in

$$\begin{aligned}
&Y(f/f_a)\\
&= H_1(f/f_a) \cdot X(f/f_a)\\
&+ \sum_{\alpha=0}^{N-1} H_2(\alpha, f/f_a - \alpha \bmod 1) \cdot X(\alpha) \cdot X(f/f_a - \alpha \bmod 1)\\
&+ \sum_{\beta_0=0}^{N-1} \sum_{\beta_1=0}^{N-1} H_3(\beta_0, \beta_1, f/f_a - \beta_0 - \beta_1 \bmod 1) \cdot X(\beta_0) \cdot X(\beta_1) \cdot X(f/f_a - f/f_a - \beta_0 - \beta_1 \bmod 1).
\end{aligned}$$

$$(E.59)$$

The condition for the first order of the Volterra filter module 16 is

$$Y(f/f_a) = H_{eq,1}(f/f_a) \cdot H_1(f/f_a) \cdot X(f/f_a) = X(f/f_a).$$

$$(E.60)$$

This immediately yields the following result for an arbitrary input signal spectrum $X(f/f_a)$:

$$H_{eq,1}(f/f_a) = \frac{1}{H_1(f/f_a)}$$

$$(E.61)$$

The condition for the second order of the Volterra filter module 16 is

$$\begin{aligned}
&\sum_{\mu=0}^{N-1} H_{eq,2}(\mu, f/f_a - \mu \bmod 1) \cdot X(\mu) \cdot X(f/f_a - \mu \bmod 1)\\
&= -H_{eq,1}(f/f_a) \cdot \sum_{\alpha=0}^{N-1} H_2(\alpha, f/f_a - \alpha \bmod 1) \cdot \left[H_{eq,1}(\alpha) \cdot X(\alpha)\right] \cdot \left[H_{eq,1}(f/f_a - \alpha \bmod 1) \cdot X(f/f_a - \alpha \bmod 1)\right].
\end{aligned}$$

$$(E.62)$$

This yields the following result:

$$H_{eq,2}(f_0/f_a, f_1/f_a) = -H_{eq,1}(f_0/f_a + f_1/f_a \bmod 1) \cdot H_2(f_0/f_a, f_1/f_a) \cdot H_{eq,1}(f_0/f_a) \cdot H_{eq,1}(f_1/f_a).$$

$$(E.63)$$

For the third order of the Volterra filter module 16, the frequency-domain analogues of the terms given in equation (E.55) are determined. The result is

$$T_{(1)} = -H_{eq,1}(f/f_a) \cdot \sum_{\beta_0=0}^{N-1} \sum_{\beta_1=0}^{N-1} H_3(\beta_0, \beta_1, f/f_a - \beta_0 - \beta_1 \bmod 1)$$
$$\cdot [H_{eq,1}(\beta_0) \cdot X(\beta_0)] \cdot [H_{eq,1}(\beta_1) \cdot X(\beta_1)] \cdot [H_{eq,1}(f/f_a - \beta_0 - \beta_1 \bmod 1) \cdot X(f/f_a - \beta_0 - \beta_1 \bmod 1)],$$

$$T_{(2)} = -\sum_{\alpha=0}^{N-1} H_{eq,2}(\alpha, f/f_a - \alpha) \cdot [X(\alpha) + T_{(5)}(\alpha)] \cdot [X(f/f_a - \alpha \bmod 1) + T_{(6)}(f/f_a - \alpha \bmod 1)]$$

$$T_{(5)}(\alpha) = \sum_{\beta=0}^{N-1} H_{eq,2}(\beta, \alpha - \beta \bmod 1) \cdot [H_{eq,1}(\beta) \cdot X(\beta)] \cdot [H_{eq,1}(\alpha - \beta \bmod 1) \cdot X(\alpha - \beta \bmod 1)]$$

$$T_{(6)}(f/f_a - \alpha \bmod 1)$$
$$= \sum_{\beta=0}^{N-1} H_{eq,2}(\beta, f/f_a - \alpha - \beta \bmod 1) \cdot [H_{eq,1}(\beta) \cdot X(\beta)] \cdot [H_{eq,1}(f/f_a - \alpha - \beta \bmod 1) \cdot X(f/f_a - \alpha - \beta \bmod 1)]$$

$$T_{(3)} = +\sum_{\alpha=0}^{N-1} H_{eq,2}(\alpha, f/f_a - \alpha) \cdot X(\alpha) \cdot X(f/f_a - \alpha)$$

$$T_{(4)} = +\sum_{\alpha=0}^{N-1} H_{eq,2}(\alpha, f/f_a - \alpha)$$
$$\cdot \left\{ \sum_{\beta_0=0}^{N-1} H_2(\beta_0, \alpha - \beta_0 \bmod 1) \cdot [H_{eq,1}(\beta_0) \cdot X(\beta_0)] \cdot [H_{eq,1}(\alpha - \beta_0 \bmod 1) \cdot X(\alpha - \beta_0 \bmod 1)]) \right\}$$
$$\cdot \left\{ \sum_{\beta_1=0}^{N-1} H_2(\beta_1, f/f_a - \alpha - \beta_1 \bmod 1) \cdot [H_{eq,1}(\beta_1) \cdot X(\beta_1)] \right.$$
$$\left. \cdot [H_{eq,1}(\beta_1, f/f_a - \alpha - \beta_1 \bmod 1) \cdot X(\beta_1, f/f_a - \alpha - \beta_1 \bmod 1)]) \right\}.$$

$$(E.64)$$

For the calculation of the transfer function $H_{eq,3}$ of the third order of the Volterra filter module 16, only product spectra $X(f_0/f_a) \cdot X(f_1/f_a) \cdot X(f_2/f_a)$ with three frequencies may contribute. It has turned out that terms that do not meet this condition completely cancel each other.

Accordingly, it holds

$$T_{(2)} = -\sum_{\alpha=0}^{N-1} H_{eq,2}(\alpha, f/f_a - \alpha) \cdot T_{(5)} \cdot T_{(6)} = -T_{(4)}$$

$$-\sum_{\alpha=0}^{N-1} H_{eq,2}(\alpha, f/f_a - \alpha) \cdot X(\alpha) \cdot X(f/f_a - \alpha) = -T_{(3)}.$$

(E.65)

The result for the third order transfer function of the Volterra filter module 16 has two contributions, namely $H_{eq,3}^{(1)}$ and $H_{eq,3}^{(2)}$, which are given by

$$H_{eq,3}^{(1)}(f_0/f_a, f_1/f_a, f_2/f_a)$$
$$= -H_{eq,1}(f_0/f_a + f_1/f_a + f_2/f_a \bmod 1) \cdot H_3(f_0/f_a, f_1/f_a, f_2/f_a) \cdot H_{eq,1}(f_0/f_a) \cdot H_{eq,1}(f_1/f_a) \cdot H_{eq,1}(f_2/f_a).$$

$$H_{eq,3}^{(2)}(f_0/f_a, f_1/f_a, f_2/f_a)$$
$$= -H_{eq,2}(f_0/f_a, +f_1/f_a + f_2/f_a \bmod 1) \cdot H_{eq,2}(f_0/f_a, f_1/f_a) \cdot H_{eq,1}(f_1/f_a) \cdot H_{eq,1}(f_2/f_a)$$
$$- H_{eq,2}(f_1/f_a + f_2/f_a \bmod 1, f_0/f_a) \cdot H_{eq,2}(f_1/f_a, f_2/f_a) \cdot H_{eq,1}(f_1/f_a) \cdot H_{eq,1}(f_2/f_a).$$

(E.66)

The third order transfer function of the Volterra filter module 16 is then given by

$$H_{eq,3}(f_0/f_a, f_1/f_a, f_2/f_a) = H_{eq,3}^{(1)}(f_0/f_a, f_1/f_a, f_2/f_a) + H_{eq,3}^{(2)}(f_0/f_a, f_1/f_a, f_2/f_a)$$

(E.67)

With the technique described in equations (E.59) to (E.67), reference transfer functions $H_{eq,ref,m}(f_0/f_a, ..., f_{m-1}/f_a)$ are determined in the frequency domain.

Alternatively, the reference transfer functions may be determined based on the reference impulse responses $h_{eq,ref,m}(k_0, k_1, k_2)$ by means of a Fourier transform.

The (final) filter coefficients $h_{eq,m}$ of the Volterra filter module 16 can then be determined by means of a minimum square technique as described in equations (E.38) to (E.47) applied to the reference transfer functions $H_{eq,ref,m}(f_0/f_a, ..., f_{m-1}/f_a)$.

Therein, a desired structure can be imposed on the filter coefficients $h_{eq,m}$, e.g. a memory polynomial structure, an extended memory polynomial structure, or otherwise pruned impulse responses.

With the spectral weighting function W, the spectral quality of the Volterra filter module 16 can be controlled. It has turned out that a particular high equalization accuracy for equalizing unwanted non-linear disturbances is achievable this way.

It is to be understood that while the method above is described in the context of the single non-linear electronic component 12 causing the non-linear distortions, the method can readily be applied to several non-linear electronic components and/or to a whole non-linear electronic system comprising several non-linear electronic components that are interconnected.

Accordingly, filter coefficients of the Volterra filter module 16 may be adapted such that the equalizer module 14 is configured to equalize the non-linear electronic system.

In other words, the Volterra filter module 16 processes the output signal y of the non-linear electronic component 12, thereby generating an equalized output signal $y_{eq}$ that corresponds to the output signal y of the non-linear electronic component 12, but with the non-linear distortions removed.

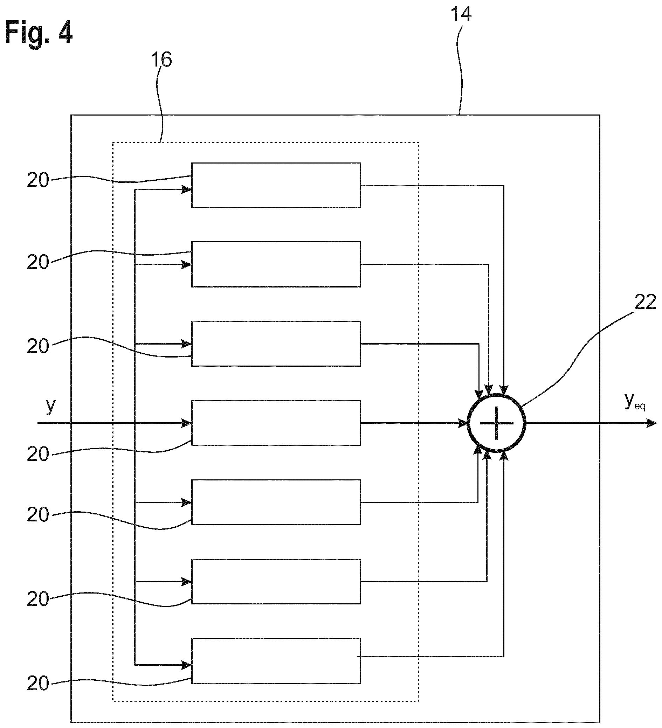

Figure 4 shows one possible implementation of the equalizer module 14 with the Volterra filter module 16. The equalizer module 14 is established as a digital filter circuit.

The Volterra filter module 16 comprises several short-length finite impulse response (FIR) filters 20 that are arranged in parallel.

The FIR filters 20 each are established in hardware. For example, the FIR filters 20 each may comprise FPGAs and/or ASICs.

Each of the short-length FIR filters 20 is configured to receive signal samples that are associated with the output signal y of the non-linear electronic component 12 (the output signal of the y of the non-linear electronic component 12 is the input signal of the equalizer module 14).

In the following, the output signal y of the non-linear electronic component is denoted as "filter input signal", and the equalized output signal $y_{eq}$ is denoted as "filter output signal".

Each short-length FIR filter 20 receives a product of at least two filter input signal samples, i.e. the filter input signal associated with each short-length FIR filter 20 comprises a product of at least two filter input signal samples, i.e. a product

$$x(t_0/T_a - 0, \ldots, t_0/T_a - \mu_{m-1}) = \prod_{\alpha=0}^{m-1} x(t_0/T_a - \mu_\alpha).$$

(E.68)

The short-length FIR filters 20 are each configured to determine one term of the second Volterra series as defined in equation (E.1) or (E.14), but with the impulse responses h being replaced by the determined filter coefficients $h_{eq}$.

Therein, different FIR filters 20 are associated with different diagonals of the second Volterra series.

In general, the number of necessary FIR filters 20 depends on the maximum order M of the second Volterra series and on the number of non-zero diagonals of the second Volterra series.

As already explained above, the maximum order of the second Volterra series is M = 3.

For example, the second Volterra series may comprise $D_2 = D_3 = 2$ non-zero diagonals. In this case, one FIR filter 20 is necessary for determining the first order (m = 1) term of the second Volterra series. Two FIR filters 20 are necessary for determining the second order (m = 2) term of the second Volterra series. Four FIR filters 20 are necessary for determining the third order (m = 3) term of the third order Volterra series.

Thus, in the particular example shown in Figure 4, the Volterra filter module 16 comprises seven FIR filters 20.

Each FIR filters 20 determines one term of the second Volterra series based on the filter input signal y and based on the filter coefficients $h_{eq}$. Thus, the output signal of each FIR filter 20 is associated with one term of the second Volterra series, i.e. with a certain diagonal of the second Volterra series.

The output signals of all FIR filters 20 are summed by means of a summation circuit 22, thereby generating the equalized output signal $y_{eq}$.

It has turned out that product signals as defined in equation (E.68) can be processed in a particularly resource-efficient manner by means of short-length FIR filters. Thus, the present disclosure provides a particularly resource-efficient equalizer module for equalizing non-linear systems.

In fact, it has turned out that the equalizer module 14 described above is capable of equalizing the filter input signal y in real time, even at high sample rates up to several 10 GHz.

Certain embodiments disclosed herein, particularly the respective module(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A method for determining filter coefficients of an equalizer module (14) for equalizing a non-linear electronic system, wherein the equalizer module (14) comprises a Volterra filter module (16), and wherein the method comprises the following steps:

   - providing an input signal;
   - processing the input signal by means of the non-linear electronic system, thereby obtaining an output signal;
   - providing a first mathematical model, wherein the first mathematical model describes the non-linear electronic system in terms of a first Volterra series;
   - providing a second mathematical model, wherein the second mathematical model describes the Volterra filter module (16) in terms of a second Volterra series;
   - determining reference transfer functions of the Volterra filter module (16) by means of a Pth order inverse technique based on the first Volterra series; and
   - determining filter coefficients of the Volterra filter module based on the determined reference transfer functions and based on the second Volterra series.

2. The method of claim 1, **characterized in that** an order of the first Volterra series and/or an order of the second Volterra series is smaller than or equal to three.

3. The method of claim 1 or 2, **characterized in that** transfer functions or impulse responses of the non-linear electronic system are determined based on the input signal, the output signal, and the first Volterra series, wherein the reference transfer functions of the Volterra filter module (16) are determined based on the determined transfer functions or impulse responses of the non-linear electronic system.

4. The method according to any of the preceding claims, **characterized in that** the filter coefficients of the Volterra filter module (16) are determined based on the determined reference transfer functions via a least squares method.

5. The method of claim 4, wherein a cost functional is provided, wherein the cost functional describes a spectral error signal power in dependence of the reference transfer functions, and wherein the cost functional is minimized in order to determine the filter coefficients of the Volterra filter module (16).

6. The method of claim 5, **characterized in that** the cost functional comprises a spectral weighting function.

7. The method according to any of the claims 3 to 6, **characterized in that** the reference transfer functions of the Volterra filter module (16) are obtained by means of a Pth order inverse technique in frequency domain or in time domain.

8. The method according to any of the preceding claims, **characterized in that** the filter coefficients of the Volterra filter module (16) are pruned.

9. The method according to claim 8, **characterized in that** the filter coefficients are pruned such that frequency superpositions are reduced.

10. The method according to any of the preceding claims, **characterized in that** the input signal is a multi-frequency signal, wherein the multi-frequency signal comprises several different signal components having a different predefined frequency, respectively, particularly wherein the multi-frequency signal comprises at least three different signal components.

11. The method of claim 10, **characterized in that** the predefined frequencies are chosen such that frequency superpositions are reduced.

12. The method according to any of the preceding claims, **characterized in that** the first Volterra series is determined based on the input signal and the output signal.

13. An equalizer module for equalizing a non-linear electronic system, wherein the equalizer module (14) comprises a Volterra filter module (16), and wherein filter coefficients of the Volterra filter module (16) are determined by means of a method according to any of the preceding claims.

14. An electronic device, comprising an equalizer module (14) according to claim 13.

15. The electronic device of claim 14, wherein the electronic device (10) is established as at least one of a measurement instrument, a broad-band amplifier, an analog-to-digital converter, a digital-to-analog converter, and a signal generator.

16. The electronic device of claim 14 or 15, **characterized in that** the electronic device (10) is established as an oscilloscope.

EP 4 084 425 A1

**Fig. 1**

10

12

14  16

x → [ ] → y → [ [ ] ] → y_eq

**Fig. 2**

10

18

14  16  12

[ ] → x → [ [ ] ] → [ ] → y

25

# Fig. 3

S1 — provide input signal

S2 — generate output signal

S3 — determine transfer functions of non-linear electronic component

S4 — determine impulse response of non-linear electronic component

S5 — determine filter coefficients of Volterra filter module

**Fig. 4**

Europäisches
Patentamt
European
Patent Office
Office européen
des brevets

## EUROPEAN SEARCH REPORT

**Application Number**

EP 21 17 1281

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 911 029 B1 (VELAZQUEZ SCOTT R [US] ET AL) 2 February 2021 (2021-02-02) <br> * column 9 - column 20; figures 14A, 21-22 * <br> * column 24 * <br> * column 27 * <br> ----- | 1-16 | INV. <br> H04L25/03 |
| X | JIE PAN ET AL: "Nonlinear Electrical Predistortion and Equalization for the Coherent Optical Communication System", JOURNAL OF LIGHTWAVE TECHNOLOGY, IEEE, USA, <br> vol. 29, no. 18, <br> 1 September 2011 (2011-09-01), pages 2785-2789, XP011382521, <br> ISSN: 0733-8724, DOI: 10.1109/JLT.2011.2164056 <br> * section II * <br> ----- | 1-16 | |
| X | M. SCHETZEN: "Theory of pth-order inverses of nonlinear systems", IEEE TRANSACTIONS ON CIRCUITS AND SYSTEMS, vol. 23, no. 5, 1 May 1976 (1976-05-01), pages 285-291, XP055361701, US <br> ISSN: 0098-4094, DOI: 10.1109/TCS.1976.1084219 <br> * sections II-III * <br> ----- | 1-16 | **TECHNICAL FIELDS SEARCHED (IPC)** <br><br> H04L <br> H03F <br> H03M |

The present search report has been drawn up for all claims

| Place of search | Date of completion of the search | Examiner |
|---|---|---|
| Munich | 15 October 2021 | El Hajj Shehadeh, Y |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 21 17 1281

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2021

| Patent document cited in search report | | Publication date | Patent family member(s) | Publication date |
|---|---|---|---|---|
| US 10911029 | B1 | 02-02-2021 | NONE | |

EPO FORM P0459

For more details about this annex : see Official Journal of the European Patent Office, No. 12/82